# EUROPÄISCHE PATENTSCHRIFT

(11) **EP 0 564 791 B1**
(45) Veröffentlichungstag und Bekanntmachung des Hinweises auf die Patenterteilung: **28.04.1999**
(21) Anmeldenummer: 93102445.9
(22) Anmeldetag: 17.02.1993
(51) Int. Cl.: H04L 12/40, H04L 25/00

(54) **Potentialfreie Datenschnittstelle**
Potential-free data interface
Interface de données à potentiel libre

(30) Priorität: 21.02.1992 DE 4205241
(43) Veröffentlichungstag der Anmeldung: 13.10.1993
(73) Patentinhaber: Micronas Intermetall GmbH, 79108 Freiburg (DE)
(72) Erfinder: Heberle, Klaus, Dipl.-Ing., W-7801 Reute (DE)

(56) Entgegenhaltungen:
- EP-A- 0 044 685
- PATENT ABSTRACTS OF JAPAN vol. 011, no. 363 (E-560) 26. November 1987 & JP-A-62 136 145 ( FUJI FACOM CORP ) 19. Juni 1987
- POWERCONVERSION & INTELLIGENT MOTION Bd. 15, Nr. 5, Mai 1989, VENTURA,CA US Seiten 70 - 74 R. VIG 'Smart Sensor Provides Magnetic Detection With Simplified System Wiring'

## Beschreibung

Die Erfindung betrifft eine potentialfreie Datenschnittstelle, insbesondere für monolithisch integrierte Schaltungen. Es gibt viele Anwendungsbereiche, bei denen die Daten potentialfrei abgenommen werden müssen, wenn beispielsweise infolge langer und gestörter Datenleitungen die Potentialschwankungen zwischen der Datenquelle und der Datensenke zu groß sind, so daß die Daten falsch erkannt oder die zugehörigen Schaltungen durch übergroße Spannungsspitzen sogar zerstört werden. gewisse Abhilfe schafft die Übertragung der Daten als Differenzsignale über eine Zweidrahtleitung und die Auswertung mittels einer Eingangsdifferenzstufe, die bekanntlich Gleichpegelschwankungen unterdrücken kann, sofern sie im zulässigen Aussteuerbereich liegen. Eine weitere bekannte Maßnahme stellen Optokoppler dar, die als potentialfreie Datenschnittstelle zwischen die jeweilige Schaltung und den Datenbus eingefügt werden. Die Verwendung von Optokopplern ist aber aufwendig und erfordert auf jeden Fall zusätzliche Schaltungen.

In "Patent Abstracts of Japan", Band 011, Nr. 363 (E-560) vom 26. November 1987 ist eine japanische Patentveröffentlichung JP-A-62/136140 (Fuji Facom Corp.) (Veröffentlichungstag: 19. Juni 1987) eines Datenübertragungssystems mit einer Meister- und mehreren Sklavenstationen angegeben, bei der kontaktlos über Spulen oder Halleffekt-Elemente der Strom und damit die übertragenen Daten der Datenübertragungsleitung an den jeweiligen Sklavenstationen abgegriffen werden. Die einzelnen Sklavenstationen sind jedoch senderseitig mit der Übertragungsleitung durch Stromeinspeisemittel galvanisch verbunden.

Die Fachzeitschrift "Power Conversion & Intelligent Motion", Band 15, Nr. 5, Mai 1989, Ventura, CA US enthält auf den Seiten 70 bis 74 von Ravi Vig ein Aufsatz mit dem Titel: "Smart Sensor Provides Magnetic Detection With Simplified System Wiring." Dort werden zweibeinige CMOS-Schaltungen, die mitintegrierte Halleffekt-Sensoren zur Messung des magnetischen Umfelds aufweisen, als Sklavenstationen betrieben. Im Betriebsfall steuert ein Mikroprozessor als Meisterstation über eine Anpassungsschaltung einen Zweitradbus, an dem die einzelnen Sklavenstationen parallel angeschlossen sind. Der Zweidrahtbus dient dabei sowohl der Energieversorgung der einzelnen Sklavenstationen als auch der Datenübertragung. Die Meisterstation kann die einzelnen Sklavenstationen einzeln adressieren und bekommt von ihnen über eine Datenrückmeldung die Größe des von der jeweiligen Sklavenstation gemessenen magnetischen Umfeldes zurückgemeldet. Der bidirektionale Datenaustausch zwischen der Meisterstation und der jeweils addressierten Sklavenstation erfolgt mittels einer Amplituden- oder Strommodulation auf der Zweidrahtleitung, die jedoch nur so hoch ist, daß die Energieversorgung der Sklavenstationen sicher gewährleistet bleibt.

Es ist daher Aufgabe der Erfindung, eine potentialfreie Datenschnittstelle anzugeben, die insbesonders für monolithisch integrierte Schaltungen geeignet ist und sich mit diesen gemeinsam auf einem Chip realisieren läßt.

Diese Aufgabe wird durch eine spezifische potentialfreie Datenschnittstelle gemäß Anspruchs 1 gelöst.

Der Grundgedanke der Erfindung besteht darin, als potential freie Datenschnittstelle eine Hallspannungs-Meßeinrichtung zu verwenden, die das Magnetfeld einer stromdurchflossenen Koppelschleife auswertet. Der zeitliche Verlauf des Stromes stellt dabei die übertragene Dateninformation dar. Nach den europäischen Patentanmeldungen EP-A-0 525 235, "Hallsensor mit Selbstkompensation" und EP-A-0 548 391 "Offsetkompensierter Hallsensor" lassen sich derartigen Hallspannungs-Meßeinrichtungen auf vorteilhafte Weise monolithisch mittels der üblichen Halbleiter-Herstellungsverfahren auf einem Halbleiterchip integrieren, wobei durch geeignete Schaltungen die material- und temperaturabhängigen Toleranzen der eigentlichen Hall-Elemente weitgehend unschädlich gemacht werden können. Die Anordnung und Größe der Koppelschleife ist unkritisch. Sie kann auf dem Halbleiterchip mitintegriert werden, wobei die Potentialtrennung beispielsweise durch eine dicke Oxidschicht auf dem Halbleiterchip erfolgt. Die Koppelschleife kann sich aber auch außerhalb der integrierten Schaltung befinden und braucht dann nicht einmal Anschlußkontakte auf der Chipoberfläche. Der größere Abstand zwischen dem Hallelement und der Koppelschleife erfordert natürlich ein größeres Magnetfeld.

Ein ganz besonderer Vorteil der Halleffekt-Datenschnittstelle liegt darin, daß vom Prinzip her die Koppelschleife niederohmig ist und der Spannungsabfall gering bleibt. Es können daher eine Vielzahl derartiger Schnittstellen hintereinander geschaltet werden. Durch die Niederohmigkeit ist die Empfindlichkeit der Datenleitung für kapazitive Störsignale gering. Die magnetischen Einkopplungen können durch eine verdrillte Zweidrahtleitung ebenfalls klein gehalten werden. Diese günstigen Eigenschaften sind besonders bei der Verwendung im Automobilsektor von Vorteil, weil dort die Datenquellen und -senken räumlich weit getrennt und durch eine Vielzahl von Störquellen gestört sind.

Die Erfindung und weitere Vorteile werden nun anhand der Figuren der Zeichnung näher erläutert:
Fig. 1 zeigt schematisch eine unidirektionale Halleffekt-Datenschnittstelle,
Fig. 2 zeigt schematisch eine Datenquelle und drei Empfängerschaltungen, die über einen Zweidrahtbus in Reihe geschaltet sind,
Fig. 3 zeigt schematisch als Beispiel das Datenformat der übertragenen Daten,
Fig. 4 zeigt schematisch ein Ausführungsbeispiel einer bidirektionalen Schnittstelle,
Fig. 5 zeigt schematisch eine Datentaktperiode im Abfrageintervall und
Fig. 6 zeigt schematisch ein anderes Ausführungsbeispiel einer bidirektionalen Datenschnittstelle.

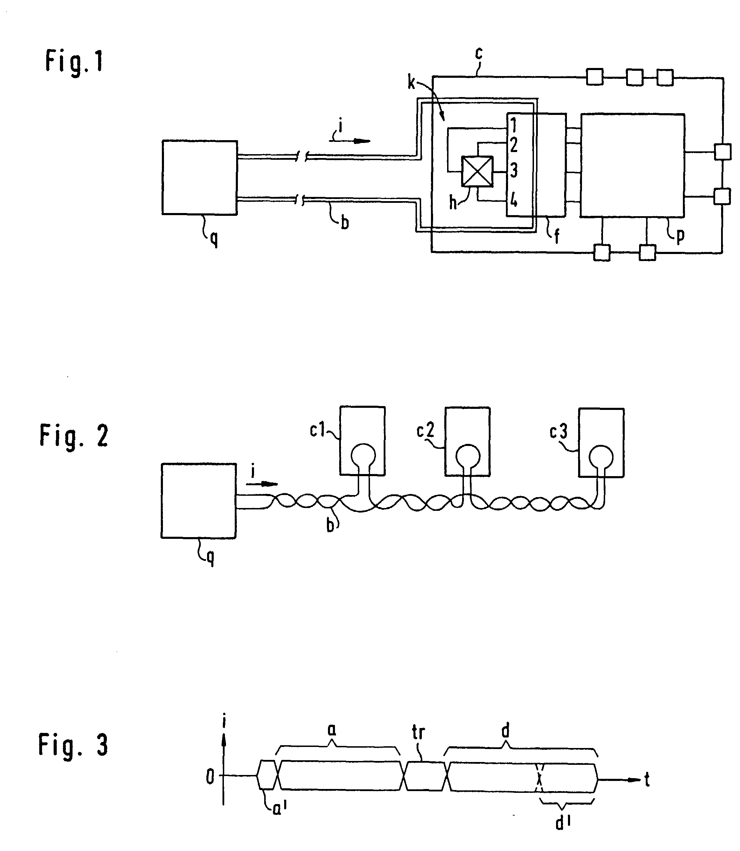

In Fig. 1 ist eine Datenquelle q über eine Buleitung b mit einer integrierten Schaltung c verbunden. Über die Busleitung fließt ein Strom i, der als Information im einfachsten Fall ein binäres Signal oder ein Datenwort enthält. Die Datenquelle q kann beispielsweise ein zentraler Prozessor sein, der über die Busleitung b eine Signalverarbeitungsschaltung p steuert, indem er dieser ein einzelnes Steuersignal oder in serieller Form Daten bzw. Befehle zuführt. Die Signalverarbeitungsschaltung p ist innerhalb der integrierten Schaltung c mit einer Hallspannungs-Meßeinrichtung verbunden, die aus einer Fühlereinrichtung f und mindestens einem Hallelement h besteht. Die Fühlereinrichtung f liefert dabei beispielsweise zwischen den Anschlüssen 2 und 4 den Strom für das Hallelement h und greift zwischen den Anschlüssen 1 und 3 die jeweilige Hallspannung ab. Mittels interner Schaltereinrichtungen, entsprechend der vorgenannten europäischen Patentanmeldung "Offsetkompensierter Hallsensor", können die Anschlüsse 1 bis 4 während der Abfrage auch vertauscht werden - dadurch lassen sich die richtungsabhängigen Eigenschaften des einen oder der zusammenwirkenden Hallelementes h nahezu vollständig kompensieren. Die Koppelschleife k ist in Fig. 1 lediglich mit einer Windung angedeutet, die sich außerhalb der integrierten Schaltung c befindet. Mehrere Windungen erhöhen die Empfindlichkeit.

In Fig. 2 ist die Busleitung b als verdrillte Zweidrahtleitung dargestellt, die von der Datenquelle q mit dem datenabhängigen Strom i gespeist ist. Eine erste, zweite und dritte Schaltung c1, c2, c3 sind seriell über jeweils eine Koppelschleife an die Busleitung b angeschlossen.

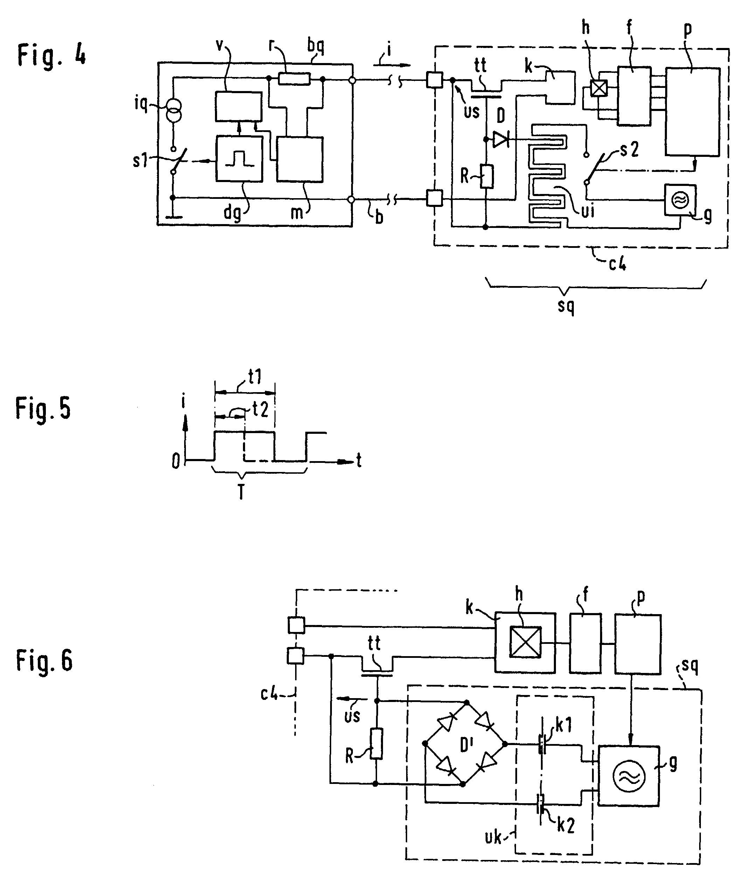

In Fig. 3 ist als Beispiel ein Datenformat dargestellt, das durch den datenabhängigen Strom i auf der Busleitung b übertragen wird. Der jeweilige logische Zustand wird durch einen ersten oder zweiten Stromwert übertragen, wobei einer dieser Stromwerte auch Null sein kann. Der erste Stromwert kann auch positiv und der zweite negativ sein. Die Schaltung hierfür ist etwas aufwendiger, bringt jedoch Vorteile durch den doppelten Hub und die gleichmäßigere Strombelastung. Das Datenformat kann mit einem Start- oder Synchronzeichen a' beginnen. Ihm schließt sich ein Adreßteil a, ein Trennzeichen tr und ein Datenteil d an, der unter Umständen ein Abfrageintervall d' enthält, in dem entsprechend Fig. 4 oder Fig. 5 die angesprochene Schaltung c4 Daten an die Datenquelle bq zurücksenden kann. Diese wirkt somit als Masterstufe, indem sie je nach Belieben Daten aus den einzelnen Unterstufen abfrägt. Dies ist allerdings nur möglich, wenn die potentialfreie Datenschnittstelle in beiden Richtungen wirksam ist. Zwei derartige Ausführungsbeispiele zeigen Fig. 4 und Fig. 6.

Wenn die Auflösung der Hallelement-Meßeinrichtung h, f mehr als zwei Strompegel sicher unterscheiden kann, können auch mehrwertige Datensignale übertragen werden.

Die bidirektionale Datenschnittstelle nach Fig. 4 enthält außer den bereits bekannten Schaltungsteilen, die mit den gleichen Bezugszeichen versehen sind, weitere Schaltungsteile. Wie in Fig. 1 ist eine Datenquelle bq über eine zweiadrige Busleitung b mit einer Schaltung c4 verbunden, die auf Aufforderung jedoch Daten an die Datenquelle bq zurücksenden kann. Dies erfolgt mittels einer Unterbrecherstufe tt, die in der abgefragten Schaltung c4 die Busleitung b oder die Koppelschleife k auftrennt. Mittels einer Stromfühlereinrichtung m und eines Fühlerwiederstandes r in der Datenquelle bq erkennt diese, daß kein Strom i fließt, obwohl ein taktgesteuerter Datengenerator dg mittels eines ersten Schalters s1 eine Stromquelle iq an die Busleitung b angeschlossen hat. Aus dem Widerspruch zwischen dem Soll- und Ist-Zustand auf der Busleitung b erkennt eine Vergleichsschaltung v, daß die Unterbrecherstufe tt von der abgefragten Schaltung c4 aktiviert wurde.

Die Unterbrecherstufe tt besteht beispielsweise aus einem MOS-Transistor vom Anreicherungstyp, im folgenden auch als Unterbrechertransistor tt bezeichnet, dessen Drain- Source-Strecke in Serie zur Koppelschleife k liegt. Dabei wird zwischen die Gate- und Source-Elektrode eine Steuerspannung us geschaltet, die in einer Steuerspannungsquelle sq durch Gleichrichtung aus einem Hochfrequenzsignal gewonnen wird. Auf dem Halbleiterchip befindet sich hierzu eine monolithisch integrierte Hochfrequenzübertragungsstufe ui, deren Primärseite von einem Hochfrequenzgenerator g gespeist ist und deren Sekundärseite die Steuerspannung us nach der Gleichrichtung liefert. Dabei kann die Hochfrequenzübertragungsstufe ui sehr klein ausgebildet werden, weil die zu übertragende Frequenz hoch ist und die Steuerspannung us nur die Gate-Kapazität des Unterbrechertransistors tt umladen muß. Die Entladung der Gate-Kapazität erfolgt im einfachsten Fall durch einen hochohmigen Widerstand R oder durch andere passive oder aktive Schaltungsmaßnahmen. Die datenbezogene Ein- und Ausschaltung der Hochfrequenzübertragungsstufe ui erfolgt durch einen Steuerausgang der Signalverarbeitungsschaltung p, die entweder direkt auf den Hochfrequenzgenerator g einwirkt oder mittels eines zweiten Schalters s2 die Primärseite schließt oder öffnet.

Die Verwendung eines MOS-Transistors vom Anreicherungstyp hat auch den Vorteil, daß die betroffene Koppelschleife auch im spannungslosen Zustand der zugehörigen Schaltung c4 geschlossen bleibt. Dies ermöglicht einen "stand-by-Betrieb", indem beispielsweise nur wenige Schaltungen aktiviert sind. Die Busleitung b darf dabei nicht unterbrochen werden. Eine Anwendung ist z.B. eine aktivierte Diebstahlsicherung im Kraftfahrzeug, bei der der Zentralprozessor nur bestimmte Sensor-Schaltungen abfragen muß, während andere Schaltungen zur Batterieschonung abgeschaltet sind.

Die Ausführung der Hochfrequenzübertragungsstufe ui ist unkritisch und daher ziemlich beliebig. In Fig. 4 ist für die induktiv wirksame Hochfrequenzübertragungsstufe ui beispielsweise eine Mäanderform gewählt. Die Primär- und Sekundärseite können sich dabei in einer Ebene oder in unterschiedlichen Ebenen befinden. Der MOS-Transistor tt, die Diode D und der Widerstand R sind ebenfalls mitintegrierte Schaltungselemente. Die Potentialfreiheit zur übrigen Schaltung muß auch im Hinblick auf die erforderliche Spannungs-Durchschlagfestigkeit sichergestellt sein, indem die Abstände zur übrigen Schaltung groß genug sind. Eine galvanische Verbindung ist somit an keiner Stelle und bei keinem Betriebszustand vorhanden.

In Fig. 5 ist eine Datentaktperiode T des Datenformats innerhalb des Abfrageintervalls d' dargestellt. Der Datengenerator dg schließt beispielsweise den ersten Schalter s1 während der Zeitdauer t1. Soll die abgefrage Schaltung c4 in der betreffenden Datentaktperiode T eine "O" an die Datenquelle bq signalisieren, dann ändert sich am Stromverlauf von Fig. 5 nichts. Soll die abgefragte Schaltung c4 jedoch eine "1" an die Datenquelle dq signalisieren, dann wird der Unterbrechertransistor tt im Intervall t1-t2 geöffnet. Der Strom i hat dann den gestrichelten dargestellten Verlauf. Die Stromflußzeit ist in der Datentaktperiode T vom Intervall t1 auf das Intervall t2 reduziert worden. Die Busleitung b wirkt sich auf die jeweilige Stromflußzeit somit ähnlich aus wie eine "verdrahtete-ODER-Logik" auf den jeweiligen Spannungspegel. Die Auswertung des Tastverhältnisses t1/t2 in der Vergleichsschaltung v gibt den zurückgemeldeten logischen Zustand an. Bitweise können auf diese Weise die Daten seriell abgefragt werden.

Eine derartige Abfrage ermöglicht beispielsweise im Kraftfahrzeug einem Zentralprozessor eine Vielzahl von Daten abzufragen, die Meßgrößen, Stellwerte oder Temperaturen usw. betreffen und für ein Steuerprogramm wichtig sind.

In Fig. 6 ist schließlich schematisch als Teilschaltung ein Ausführungsbeispiel für eine bidirektionale Datenschnittstelle dargestellt, bei der die induktive Hochfrequenzübertragungsstufe ui von Fig. 4 durch eine kapazitive Hochfrequenzübertragungsstufe uk ersetzt wurde. Die Potentialtrennung wird hierbei durch einen ersten und einen zweiten Kondensator k1, k2 sichergestellt, die mit entsprechenden Sicherheitsabständen auf der Schaltung c4 mitintegriert sind. Die Gleichrichtung des Hochfrequenzsignals auf der Sekundärseite erfolgt mittels einer Gleichrichter-Brückenschaltung D', die effektiver als eine einzelne Diode D ist. Der Hochfrequenzgenerator g kann wie in Fig. 4 ein sinus- oder rechteckförmiges Ausgangssignal zur Speisung der Hochfrequenzübertragungsstufe ui, uk liefern.

## Patentansprüche

1. Potentialfreie Datenschnittstelle zwischen einer ein Datenformat sendenden Masterstufe (q) und mindestens einer das Datenformat empfangenden Unterstufe (c) mit einer Hallspannungs-Meßeinrichtung (h, f), die über das Magnetfeld einer Koppelschleife (k) den jeweiligen Strom (i) einer an die Koppelschleife angeschlossenen Busleitung (b) als Dateninformation auswertet,
gekennzeichnet durch folgende Merkmale:
- die Hallspannungs-Meßeinrichtung (h, f) ist gemeinsam mit einer Signalverarbeitungsschaltung (p) monolithisch auf einem Halbleiterchip integriert,
- wobei die material- und temperaturabhängigen Toleranzen der Hallspannungs-Meßeinrichtung kompensiert sind,
- die Busleitung (b) und die Koppelschleife (k) sind von der monolithisch integrierten Schaltung auf dem Halbleiterchip dadurch galvanisch getrennt, daß sie
- sich außerhalb des Halbleiterchips befinden oder
- daß die Koppelschleife (k) auf dem Halbleiterchip mitintegriert, jedoch gegenüber dem Halbleiterchip durch eine isolierende Schicht getrennt ist, und
- die Busleitung (b) ist zur reduzierten Störeinstrahlung als zweiadrige Busleitung ausgeführt, wobei sämtliche Koppelschleifen (k) mittels der Busleitung (b) niederohmig in Reihe geschaltet sind.

2. Datenschnittstelle nach Anspruch 1, dadurch gekennzeichnet, daß das Datenformat mit einem Adreßteil (a) und einem Datenteil (b) übertragen wird, wobei das Datenformat von einer als Masterstufe dienenden Datenquelle (q; bq) erzeugt ist, die mittels der Adressen unterschiedliche Schaltungen (c1, c2, c3; c4), die als Unterstufen dienen, ansteuern kann.

3. Datenschnittstelle nach Anspruch 1 oder 2, dadurch gekennzeichnet, daß die Datenschnittstelle eine bidirektionale ist und daß die adressierte Unterstufe Daten über die Busleitung (b) an die Datenquelle (bq) mittels einer potential freien Unterbrecherstufe (tt) in der jeweiligen Unterstufe überträgt, die den Strom (i) in einem Abfrageintervall (d'), das innerhalb des von der Masterstufe gesendeten Datenformats liegt, definiert unterbricht.

4. Datenschnittstelle nach Anspruch 3, gekennzeichnet durch folgende Merkmale:
- die Unterbrecherstufe enthält einen Unterbrechertransistor (tt) im Strompfad der Koppelschleife (k),
- zwischen der Bezugselektrode des Unterbrechertransistors (tt) und seiner Steuerelektrode liegt eine Steuerspannungsquelle (sq) zur Erzeugung einer Steuerspannung (us) und
- die Steuerspannungsquelle (sq) ist von einer Signalverarbeitungseinrichtung (p) in der abgefragten Schaltung (c4) gesteuert.

5. Datenschnittstelle nach Anspruch 4, dadurch gekennzeichnet, daß im Abfrageintervall (b') mindestens während einer Datentaktperiode (T) das Tastverhältnis tl/t2 des Stromes (i) geändert wird.

6. Datenschnittstelle nach Anspruch 4, dadurch gekennzeichnet, daß der Unterbrechertransistor (tt) ein MOS-Transistor ist.

7. Datenschnittstelle nach Anspruch 6, gekennzeichnet durch folgende Merkmale:
- der Unterbrechertransistor (tt) ist ein MOS-Transistor vom Anreicherungstyp, dessen Gate- bzw. Source-Anschluß über eine Gleichrichtungsschaltung (D; D') mit dem zugehörigen Ausgang einer induktiven oder kapazitiven Hochfrequenzübertragungsstufe (ui; uk) gespeist ist.

8. Datenschnittstelle nach Anspruch 7, dadurch gekennzeichnet, daß auf der Primärseite die induktive oder kapazitive Hochfrequenzübertragungsstufe (ui; uk) mittels einer von der Signalverarbeitungseinrichtung (p) gesteuerten Schaltereinrichtung (s2) an den Hochfrequenzgenerator (g) angeschlossen ist oder daß der Hochfrequenzgenerator (g) von der Signalverarbeitungseinrichtung (p) ein- und ausgeschaltet wird.

9. Datenschnittstelle nach Anspruch 3, gekennzeichnet durch folgende Merkmale:
- die Datenquelle (bq) enthält eine Stromfühlereinrichtung (m), die mit einem Datengenerator (dg) und einer Vergleichsschaltung (v) gekoppelt ist und
- während des Abfrageintervalls (d') vergleicht die Vergleichsschaltung (v) den Ist-Strompegel auf der Busleitung (b) mit dem Soll-Strompegel und ermittelt anhand des Vergleichsergebnisses die aus der adressierten Schaltung (c4) abgefragten Daten.

## Claims

1. A floating data interface between a master stage (q) transmitting a data format and at least one substage (c) receiving the data format, said floating data interface comprising a Hall-voltage-measuring device (h, f) which, by sensing the magnetic field of a coupling loop (k), evaluates the respective current (i) of a bus line (b) connected to the coupling loop as data information,
characterized by the following features:
- The Hall-voltage-measuring device (h, f) and a signal-processing circuit (p) are integrated on a single semiconductor chip,
- with the material- and temperature-dependent tolerances of the Hall-voltage-measuring device being compensated for;
- the bus line (b) and the coupling loop (k) are electrically isolated from the monolithic integrated circuit on the semiconductor chip by
- being located outside the semiconductor chip or
- integrating the coupling loop (k) on the semiconductor chip but separating it from the semiconductor chip by an insulating layer; and
- to reduce electromagnetic interference, the bus line (b) is designed as a two-wire bus line, with all coupling loops (k) being connected in series by means of the bus line (b) to provide a low-impedance path.

2. A data interface as claimed in claim 1, characterized in that the data format is transferred with an address part (a) and a data part (b), said data format being generated by a data source (q; bq) serving as a master stage which can control different circuits (c1, c2, c3; c4) serving as substages by means of the addresses.

3. A data interface as claimed in claim 1 or 2, characterized in that the data interface is a bidirectional one, and that the addressed substage transfers data over the bus line (b) to the data source (bq) by means of a floating interrupter stage (tt) in the respective substage which interrrupts the current (i) in a defined manner in an interrogation interval (d') which lies within the data format transmitted by the master stage.

4. A data interface as claimed in claim 3, characterized by the following features:
- The interrupter stage comprises an interrupter transistor (tt) in the current path of the coupling loop (k);
- a control-voltage source (sq) for generating a control voltage (us) is connected between the reference electrode and the control electrode of the interrupter transistor (tt); and
- the control-voltage source (sq) is controlled by a signal-processing device (p) in the interrogated circuit (c4).

5. A data interface as claimed in claim 4, characterized in that in the interrogation interval (d'), the pulse duty factor t1/t2 is changed during at least one data clock period (t).

6. A data interface as claimed in claim 4, characterized in that the interrupter transistor (tt) is an MOS transistor.

7. A data interface as claimed in claim 6, characterized by the following features:
- The interrupter transistor (tt) is an enhancement-type MOS transistor whose gate and source terminals are fed by the associated outputs of an inductive or capacitive high-frequency transmission stage (ui; uk) via a rectifier circuit (D, D').

8. A data interface as claimed in claim 7, characterized in that on the primary side, the inductive or capacitive high-frequency transmission stage (ui; uk) is connected to a high-frequency generator (g) through a switch device (s2) controlled by the signal-processing circuit (p), or that the high-frequency generator (9) is turned on and off by the signal-processing circuit (p).

9. A data interface as claimed in claim 3, characterized by the following features:
- The data source (bq) includes a current sensor (m) which is coupled to a data generator (dg) and a comparator (v); and
- during the interrogation interval (d'), the comparator (v) compares the actual current level on the bus line (b) with the desired current level and, based on the result of the comparison, determines the data read from the addressed circuit (c4).

## Revendications

1. Interface de données à potentiel libre disposée entre un étage maître (q) envoyant un format de données et au moins un sous-étage (c) recevant le format de données, comportant un dispositif de mesure de la tension de Hall (h, f) qui évalue, sous forme d'information de donnée, par l'intermédiaire du champ magnétique d'une boucle de couplage (k), le courant respectif (i) d'une ligne de bus (b) reliée à la boucle de couplage,
caractérisée par les particularités suivantes :
- le dispositif de mesure de la tension de Hall (h, f) est intégré en commun avec un circuit de traitement de signal (p) de manière monolithique sur une plaquette de semi-conducteur
- les tolérances du dispositif de mesure de la tension de Hall (h, f) qui dépendent de la matière et de la température étant compensées
- la ligne de bus (b) et la boucle de couplage (k) sont séparées galvaniquement du circuit monolithique intégré se trouvant sur la plaquette de semi-conducteur par le fait que
- ils se trouvent à l'extérieur de la plaquette de semi-conducteur ou
- la boucle de couplage (k) st intégrée sur la plaquette de semi-conducteur mais elle est séparée de la plaquette de semi-conducteur par une couche isolante et
- la ligne de bus (b) est réalisée, pour la réduction du rayonnement parasite, sous la forme d'une ligne de bus à deux fils, toutes les boucles de couplage (k) étant branchées en série sous une faible impédance au moyen de la ligne de bus (b).

2. Interface de données selon la revendication 1, caractérisé en ce que le format de données est transmis avec une section d'adresse (a) et une section de données (b), le format de données étant produit par une source de données (q, bq) qui sert d'étage maître et qui, au moyen des adresses, peut commander différents circuits (c1, c2, c3 ; c4) qui servent de sous-étages.

3. Interface de données selon la revendication 1 ou 2, caractérisée en ce que l'interface de données est bidirectionnelle et en ce que le sous-étage adressé transmet, par l'intermédiaire de la ligne de bus (b), des données à la source de données (bq) au moyen d'un étage d'interruption (tt) à potentiel libre disposé dans le sous-étage considéré qui interrompt de manière définie le courant (i) pendant un intervalle d'interrogation (d') qui se trouve à l'intérieur du format de données envoyé par l'étage maître.

4. Interface de données selon la revendication 3, caractérisée par les caractéristiques suivantes :
- l'étage d'interruption contient un transistor d'interruption (tt) disposé dans le trajet du courant de la boucle de couplage (k)
- entre l'électrode de référence du transistor d'interruption (tt) et son électrode de commande se trouve une source de tension de commande (sq) pour la production d'une tension de commande (us) et
- la source de tension de commande (sq) est commandée par un circuit de traitement de signal (p) disposé dans le circuit en cours d'interrogation (c4)

5. Interface de données selon la revendication 4, caractérisée en ce que, pendant l'intervalle d'interrogation (b'), au moins pendant une période d'horloge de données (T), le rapport de durée de passage du courant t1/t2 du courant (i) est modifié.

6. Interface de données selon la revendication 4, caractérisée en ce que le transistor d'interruption (tt) est un transistor MOS.

7. Interface de données selon la revendication 6, caractérisée par les particularités suivantes :
- le transistor d'interruption (tt) est un transistor MOS du type à enrichissement dont la borne de porte, respectivement de source, est alimentée par l'intermédiaire d'un circuit de redressement (D, D') avec la sortie correspondante d'un étage de transmission à haute fréquence inductif ou capacitif (ui, uk).

8. Interface de données selon la revendication 7, caractérisée en ce que, sur le côté primaire, l'étage de transmission à haute fréquence inductif ou capacitif (ui, uk) est relié au générateur à haute fréquence (g) au moyen d'un dispositif de commutation (s2) commandé par le circuit de traitement de signal (p) ou en ce que le générateur à haute fréquence (g) est activé et arrêté par le circuit de traitement de signal (p).

9. Interface de données selon la revendication 3, caractérisée par les particularités suivantes :
- la source de données (bq) contient un dispositif détecteur de courant (m) qui est couplé avec un générateur de données (degrés) et un circuit de comparaison (v) et
- pendant l'intervalle d'interrogation (d'), le circuit de comparaison (v) compare le niveau de courant effectif et le niveau de courant de consigne et détermine, au moyen du résultat de la comparaison, les données demandées au circuit adressé (c4).
